# FASCICULE DE BREVET EUROPEEN

(11) **EP 1 859 321 B1**
(45) Date de publication et mention de la délivrance du brevet: **07.01.2009**
(21) Numéro de dépôt: 06726101.6
(22) Date de dépôt: 17.03.2006
(51) Int. Cl.: G03F 9/00

(54) **DISPOSITIF DE MESURE OPTIQUE PAR TRIANGULATION OPTIQUE**
OPTISCHE MESSEINRICHTUNG MIT OPTISCHER TRIANGULATION
OPTICAL MEASURING DEVICE USING OPTICAL TRIANGULATION

(30) Priorité: 18.03.2005 FR 0502729
(43) Date de publication de la demande: 28.11.2007
(73) Titulaire: Sagem Défense Sécurité, 75015 Paris (FR)
(72) Inventeur: MICHELIN, Jean-Luc, F-92270 Bois Colombes (FR)
(74) Mandataire: Cabinet Plasseraud
(86) Numéro de dépôt international: PCT/FR2006/000601
(87) Numéro de publication internationale: WO 2006/097645

(56) Documents cités:
- EP-A- 0 502 583
- WO-A-20/05029192
- US-A- 6 124 934

## Description

La présente invention concerne d'une façon générale le domaine de la mesure optique de distance et/ou d'inclinaison par triangulation optique (ou profilométrie optique), et elle concerne plus particulièrement des perfectionnements apportés aux dispositifs de mesure optique par triangulation optique pour la mesure, par rapport à une surface plane de référence et selon une direction sensiblement perpendiculaire à celle-ci, de l'écartement et de l'inclinaison selon deux directions d'une surface à mesurer localement assimilable à un plan. L'écartement ou distance ainsi que l'inclinaison peuvent être constants dans le temps ou bien être évolutifs.

Des dispositifs de mesure de ce type trouvent une application particulièrement intéressante dans le domaine de la microphotolithographie (fabrication de microcircuits sur un substrat de matériau semi-conducteur -par exemple typiquement du silicium- par insolation, au moyen d'un rayonnement lumineux par exemple ultraviolet, d'une résine déposée sur la surface de ce substrat), de manière à détecter à chaque instant l'écart de distance et/ou l'inclinaison (défaut de parallélisme) d'une portion dudit substrat semi-conducteur par rapport au plan image de l'objectif de l'appareil de microphotolithographie et à apporter en temps réel les corrections de position appropriées sur le substrat.

Une autre application très intéressante de ce type de dispositif de mesure concerne la mesure tridimensionnelle d'une surface quelconque de forme proche d'un plan : la surface à mesurer est déplacée avec précision dans un plan de référence (plan horizontal) selon deux directions perpendiculaires, de manière que la totalité de la surface soit explorée, le dispositif de mesure détectant la hauteur et la pente locale de la surface ; un traitement des mesures permet de reconstituer la surface dans son ensemble avec une précision meilleure que celle que peuvent procurer les machines de mesure tridimensionnelle standard.

Les dispositifs de mesure mis en oeuvre dans les appareils de microphotolithographie connus font appel à plusieurs techniques, à savoir la triangulation optique ou profilométrie, l'analyse de faisceau collimaté, l'interférométrie.

La technique de la triangulation optique ou profilométrie semble particulièrement intéressante en raison de la simplicité de mise en oeuvre qu'elle autorise aussi bien pour ce qui concerne les moyens optiques à utiliser que pour ce qui concerne les moyens de traitement des signaux conduisant aux informations souhaitées.

Le principe général de la triangulation optique est simple : un système optique de projection projette une image sur la surface à mesurer et l'image, réfléchie ou diffusée par la surface, est captée par un système optique de détection ; si la surface à mesurer est déplacée ou si sa forme est modifiée, l'image sur la surface se déplace ou se déforme ; ce déplacement ou cette déformation est perçu par le système optique de détection et l'image sur le plan focal est modifiée ; la mesure, sur le plan focal, de l'écart entre l'image théorique ou initiale et l'image déplacée ou modifiée fournit, par traitement des données, les informations sur le déplacement ou la déformation de la surface à mesurer.

On connaît divers dispositifs de mesure optique par triangulation optique agencés pour assurer les mesures précitées, notamment dans des appareils de microphotolithographie : voir par exemple les documents US 4 356 392, US 4 383 757, US 4 650 983, US 4 866 262, US 5 191 200, US 5 502 311, US 6 721 036.

Toutefois, ces dispositifs connus présentent divers inconvénients sur le plan structurel (par exemple pièces optiques en mouvement, telles que des miroirs oscillants) et/ou sur le plan optique (par exemple formation et détection d'image microstructurée), qui rendent les mesures insuffisamment précises (vibrations induites par les pièces mobiles), en même temps que les moyens mis en oeuvre (en particulier optiques) s'avèrent trop complexes et trop coûteux.

L'invention a donc pour but de proposer une solution technique perfectionnée basée sur la triangulation optique, qui donne mieux satisfaction aux diverses exigences de la pratique, notamment pour ce qui concerne l'obtention d'une précision de mesure et d'une fiabilité accrues, d'une plus grande simplicité dans l'agencement du dispositif, et finalement l'obtention d'un dispositif de mesure de qualités améliorées dans des conditions acceptables de coût de fabrication.

A ces fins, selon un premier de ses aspects l'invention propose un dispositif de mesure optique par triangulation optique pour la mesure, par rapport à une surface plane de référence et selon une direction sensiblement perpendiculaire à celle-ci, de l'écartement et de l'inclinaison selon deux directions d'une surface à mesurer qui est localement assimilable à un plan, lequel dispositif, étant agencé conformément à l'invention, se caractérise en ce qu'il comprend :
- des moyens émetteurs de lumière propres à émettre, avec une fréquence de répétition donnée, un faisceau lumineux alternativement dans une première plage de longueurs d'onde et dans une seconde plage de longueurs d'onde,
- des moyens diviseurs de faisceau propres à générer, à partir de chaque faisceau incident unique, plusieurs faisceaux séparés et parallèles en nombre au moins égal à trois répartis selon une configuration prédéterminée,
- un séparateur optique propre à diriger chacun des faisceaux lumineux incidents dans deux directions différentes respectivement en relation respectivement avec les deux plages de longueurs d'onde, ledit séparateur optique étant disposé latéralement, par rapport à la surface de référence et à la surface à mesurer, de manière que les deux faisceaux de sortie soient dirigés, avec des trajets de sensiblement mêmes longueurs, respectivement vers la surface de référence et la surface à mesurer sur lesquelles ils subissent des réflexions respectives de manière à converger ensuite l'un vers l'autre,
- un combineur optique de faisceaux propre à recueillir les deux faisceaux réfléchis issus d'un même faisceau incident et à les diriger sur un même trajet optique de sortie,
- des moyens capteurs pour recevoir chacun desdits faisceaux de sortie, lesdits moyens capteurs comprenant des capteurs optroniques
   - qui sont en nombre inférieur ou égal à celui des trous de l'écran,
   - qui sont disposés selon une configuration corrélée à celle des trous de l'écran de manière telle que chaque capteur optronique reçoive alternativement deux images lumineuses (par exemple sous forme de taches lumineuses) formées respectivement par les deux faisceaux réfléchis respectivement et alternativement par la surface de référence et la surface à mesurer, et
   - qui sont propres à délivrer un signal de sortie représentatif de la position du barycentre énergétique de chacune des deux images lumineuses,
- des moyens de synchronisation pour établir une relation temporelle entre la plage de longueurs d'onde du faisceau émis par les moyens émetteurs de lumière et les images formées sur les capteurs optroniques, et
- des moyens de traitement de l'ensemble des signaux délivrés par les capteurs optroniques pour fournir des informations d'écartement et d'inclinaison selon deux directions de la surface à mesurer par rapport à la surface de référence.

Dans un mode de réalisation simple qui est préféré, chaque capteur des moyens capteurs est un capteur photosensible du type sensible à la position dit capteur PSD (Position Sensitive Detector) propre à délivrer deux signaux de sortie représentatifs de la position du barycentre énergétique de chacune des deux images lumineuses

Toujours dans un mode de réalisation préféré des dispositions conformes à l'invention, les moyens émetteurs de lumière comprennent :
- au moins une source de lumière émettant un faisceau lumineux dans une bande de longueurs d'ondes englobant les susdites première et seconde plages, et
- un modulateur optique propre à isoler, dans ledit faisceau lumineux, lesdites première et seconde plages de longueurs d'ondes de façon alternée dans le temps selon un cycle de fréquence prédéterminée.

En pratique, notamment en vue de l'application à la microphotolithographie, la fréquence d'échantillonnage est liée à la bande passante requise de l'asservissement en position du substrat. Cette fréquence d'échantillonnage est comprise typiquement entre 1 et 10 kHz, et de préférence elle est d'environ 2,5 kHz.

Dans un mode de réalisation possible qui peut trouver un intérêt notamment dans le domaine de la microphotolithographie mettant en oeuvre un rayonnement lumineux (par exemple ultraviolet), les moyens émetteurs de lumière émettent dans une plage de longueurs d'ondes dans le rouge et/ou le proche infrarouge qui n'interfère pas avec la résine photosensible déposée sur le substrat lors du processus de fabrication de microcircuits électroniques évoqué plus haut. On peut notamment alors prévoir que les deux plages précitées de longueurs d'ondes sont respectivement la plage d'environ 600 - 630 nm pour le faisceau dirigé vers la surface de référence et la plage d'environ 670 - 1050 nm pour le faisceau dirigé vers la surface à mesurer, la zone intermédiaire d'environ 630 - 670 nm entre ces deux plages pouvant être ajustée.

Pour ce qui concerne les moyens diviseurs de faisceau, diverses solutions peuvent être envisagées. Une solution simple à mettre en oeuvre peut consister en ce que lesdits moyens diviseurs de faisceau comprennent un écran qui comporte au moins trois trous de forme prédéfinie disposés selon une configuration prédéterminée et qui est propre à être éclairé alternativement par lesdits faisceaux lumineux.

Toujours dans un mode de réalisation préféré, le séparateur optique et le combineur optique sont des composants optiques statiques opérant par réfraction et réflexion en fonction des longueurs d'onde.

La mise en oeuvre des dispositions conformes à l'invention, et notamment la mise en oeuvre conjointe de l'ensemble de ces dispositions, procure des avantages nombreux et intéressants.

Un avantage important réside dans le fait que, à l'exception des trajets différenciés entre le séparateur et le combineur de faisceaux, les deux faisceaux suivent exactement le même chemin optique, en traversant ou se réfléchissant sur les mêmes composants optiques. Or la position relative de la surface mesurée par rapport à la surface de référence ne dépend que de l'écart entre le trajet optique des deux faisceaux. Ainsi, toute modification des caractéristiques des composants optiques et/ou du trajet optique - notamment face à des dérives thermiques, à des vibrations, à des dérives à long terme telles que celles dues au vieillissement, ... - influe identiquement sur les deux faisceaux de sorte que des recalages relatifs ne sont pas nécessaires.
Un autre avantage important est que la mesure de la position relative de la surface à mesurer par rapport à la surface de référence est indépendante de la position du système de mesure par rapport auxdites surfaces, ce qui rend le dispositif de mesure insensible aux vibrations et variations de position du dispositif de mesure

Un autre avantage important tient au fait que tous les composants optiques sont entièrement statiques et ne comportent aucune pièce mobile, en particulier pour la réalisation des séparateur et combineur optiques des faisceaux : l'absence de pièces en mouvement évite les vibrations, ce qui présente un intérêt primordial en particulier dans l'application plus spécifiquement envisagée aux appareils de microphotolithographie pour lesquels les moindres vibrations sont des causes de désordres importants dans la fabrication des microcircuits intégrés.

Au surplus, l'absence de pièces en mouvements relatifs écarte les frottements entre pièces qui sont à l'origine de la formation de poussières par exemple métalliques dont la présence peut être très pénalisante, notamment, là encore, dans les appareils de microphotolithographie qui fonctionnent sous atmosphère propre.

Enfin, le recours, comme exposé plus haut, à des composants électroniques photosensibles du type sensible à la position PSD, qui sont propres à délivrer un signal de sortie représentatif de la position du barycentre énergétique des deux taches lumineuses formées par les deux faisceaux lumineux, pour constituer les capteurs représente une simplification considérable de la partie de détection du dispositif. En effet, chaque capteur est constitué intrinsèquement de manière à délivrer une information barycentrique en relation avec sa double illumination et il suffit ensuite de moyens de traitement en soi connus pour traiter l'ensemble des signaux et en déduire les informations souhaitées (sous forme de meilleures estimations des valeurs de distance et d'inclinaison) sur la position de la surface à mesurer par rapport à la surface de référence.

Au total, la mise en oeuvre d'un dispositif de mesure agencé conformément à l'invention dans un appareil de microphotolithographie peut conduire à une amélioration sensible des conditions d'utilisation de l'appareil et peut accroître de façon sensible les performances de l'appareil.

L'invention sera mieux comprise à la lecture de la description détaillée qui suit de certains modes de réalisation préférés donnés uniquement à titre d'exemples non limitatifs. Dans cette description, on se réfère aux dessins annexés sur lesquels :
- la figure 1 est une vue très schématique d'un dispositif de mesure par triangulation optique montré dans le contexte de l'application, plus spécifiquement visée par l'invention, à un appareil de microphotolithographie ;
- la figure 2 est un graphique explicitant la séparation temporelle des deux faisceaux dirigés respectivement sur la surface de référence et sur la surface à contrôler dans le dispositif de la figure 1;
- la figure 3A est une représentation schématique d'un exemple possible de répartition des taches lumineuses sur la surface à mesurer ;
- la figure 3B est une représentation schématique illustrant le fonctionnement d'un exemple préféré de capteurs utilisable dans l'agencement de la figure 3A;
- la figure 4 est une représentation schématique d'un mode de réalisation préféré des moyens émetteurs de lumière du dispositif de la figure 1;
- les figures 5A et 5B sont deux exemples de réalisation, montrés sous forme simplifiée, des moyens diviseurs de faisceau du dispositif de la figure 1; et
- les figures 6A à 6C sont des exemples respectifs de réalisation du séparateur de faisceaux du dispositif de la figure 1.

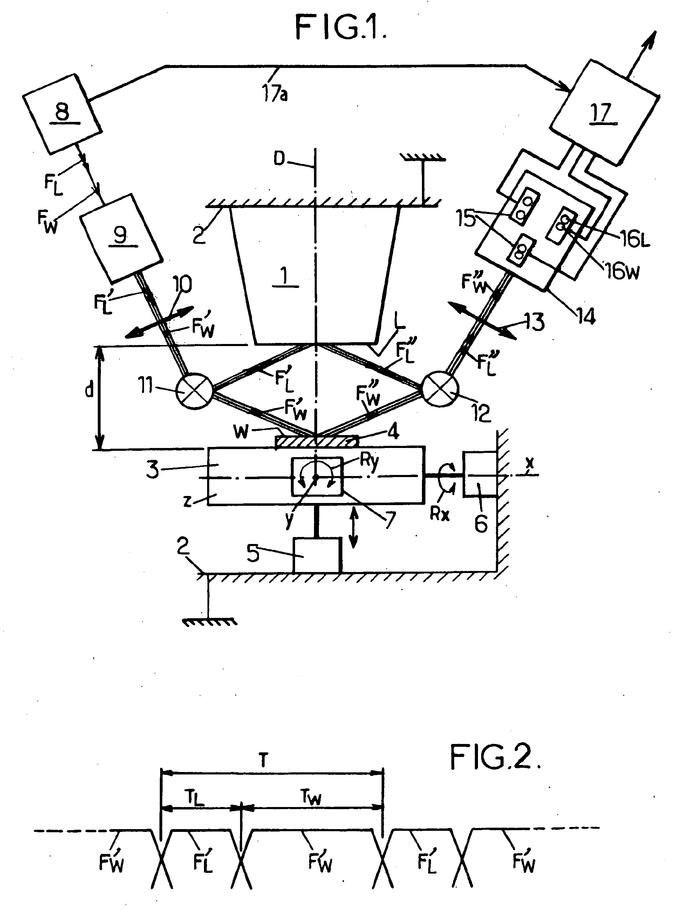

Les dispositions générales de l'invention vont maintenant être exposées avec référence aux figures 1 et 2.

A la figure 1 est représenté très schématiquement un dispositif de mesure optique par triangulation optique ou profilométrie pour la mesure, par rapport à une surface plane L de référence et selon une direction D sensiblement perpendiculaire à celle-ci, de l'écartement d et de l'inclinaison Rₓ et R_{y} selon deux directions x et y d'une surface W à contrôler qui est localement assimilable à un plan. Autrement dit, le dispositif de mesure est apte à mesurer l'attitude de la surface W par rapport à la surface de référence L, les deux directions x et y définissant la surface W à contrôler et la direction D correspondant approximativement à la direction z perpendiculaire aux directions x et y.

A la figure 1, on a schématisé le dispositif dans le contexte de l'application plus spécialement envisagée pour la mise en oeuvre pratique de l'invention, à savoir un appareil de microphotolithographie possédant un objectif 1 dont l'axe optique est la susdite direction D, qui est solidaire d'un bâti 2 de l'appareil et dont la face frontale de la lentille terminale est plane et constitue la susdite surface L de référence. En regard de l'objectif 1 est situé un support 3 qui est agencé pour supporter un élément 4 sous l'objectif 1, approximativement dans l'axe de la direction D. Dans ce contexte, l'élément 4 est une plaquette d'un matériau semi-conducteur tel que du silicium, qui est soumise à des traitements successifs de masquage sélectifs et d'insolation pour la fabrication de microcircuits intégrés à haute densité d'intégration. C'est la face supérieure de l'élément 4, tournée vers l'objectif 1, qui constitue la susdite surface W sensiblement plane au moins localement qui est à contrôler. Le support 3 est monté sur le bâti 2 de l'appareil par l'intermédiaire de moyens de réglage permettant d'ajuster son positionnement, et donc celui de la plaquette 4 qu'il supporte, en fonction des écarts détectés par le dispositif de mesure ; à cet effet, on peut prévoir que le support 3 soit soumis à l'action de trois moyens de réglage, à savoir un moyen de réglage en distance 5 fonctionnel selon la direction D pour ajuster la distance d précitée et deux moyens de réglage en rotation respectivement 6 et 7 propres à engendrer une rotation Rx du support autour de l'axe x et une rotation Ry du support autour de l'axe y, respectivement.

Le dispositif de mesure comprend des moyens émetteurs de lumière 8 propres à émettre sur une même trajectoire, avec une fréquence de répétition donnée, deux faisceaux lumineux alternatifs respectivement dans une première plage de longueurs d'onde et dans une seconde plage de longueurs d'onde. Sur la figure 1, les deux faisceaux sont représentés confondus : un faisceau FL est schématisé par une double flèche et l'autre faisceau Fw est schématisé par une simple flèche. Dans le contexte de l'application spécifique précitée, les moyens émetteurs de lumière 8 émettent dans le rouge et/ou le proche infrarouge : le faisceau FL comprend des rayonnements dans une plage de longueurs d'ondes ΔλL d'environ 600 - 630 nm et le faisceau Fw comprend des rayonnements dans une plage de longueurs d'ondes Δλw d'environ 670 - 1050 nm. Les deux faisceaux ont des durées Tw et TL qui sont inégales, comme montré à la figure 2, avec une durée de cycle d'échantillonnage T qui est liée à la bande passante requise de l'asservissement en position de l'élément 4 ; la fréquence d'échantillonnage est comprise typiquement entre 1 et 10 kHz. Dans le cadre de l'application à la microphotolithographie, le faisceau FL a une durée TL de l'ordre d'une centaine de microsecondes, tandis que le faisceau Fw a une durée Tw de l'ordre de 300 µs ; la durée totale T du cycle est d'environ 400 µs, soit une fréquence d'échantillonnage de l'ordre de 2,5 kHz.

En aval des moyens 8 émetteurs de lumière se trouvent des moyens diviseurs de faisceau 9 propres à générer, à partir de chaque faisceau FL, Fw incident unique, un faisceau lumineux multiple FL', Fw' en nombre au moins égal à trois répartis selon une configuration prédéterminée.

Après un système optique de projection 10, les faisceaux lumineux multiples parviennent à un séparateur optique 11 propre à diriger les faisceaux lumineux FL', Fw' incidents dans deux directions différentes en relation respectivement avec les deux plages de longueurs d'onde, ledit séparateur optique 11 étant disposé latéralement, par rapport à la surface de référence et à la surface à contrôler, de manière que les deux faisceaux FL', Fw' de sortie soient dirigés, avec des trajets de sensiblement mêmes longueurs, respectivement vers la surface L de référence et la surface W à contrôler.

Sur les deux surfaces L et W, les faisceaux FL' et Fw' respectivement subissent des réflexions respectives de manière à converger ensuite l'un vers l'autre, sur un combineur optique 12 de faisceaux propre à recueillir les deux faisceaux réfléchis FL", Fw" et à les diriger alternativement sur un même trajet optique de sortie.

Après avoir traversé un système optique de détection 13, les faisceaux alternatifs de sortie FL", Fw'' parviennent à des moyens capteurs 14 comprenant des capteurs optroniques 15
- qui sont en nombre inférieur ou égal à celui de la multiplicité des faisceaux divisés,
- qui sont disposés selon une configuration corrélée à celle de la multiplicité des faisceaux divisés de manière telle que chaque capteur optronique 15 reçoive alternativement deux images lumineuses 16L, 16w formées respectivement par les deux faisceaux réfléchis alternatifs FL", Fw", et
- qui sont propres à délivrer un signal de sortie représentatif de la position du barycentre énergétique des deux images lumineuses 16L, 16w.

Il est prévu ensuite des moyens 17 de traitement de l'ensemble des signaux délivrés par les capteurs optroniques 15 pour fournir finalement des informations de sortie sur l'écartement et l'inclinaison selon deux directions de la surface W à contrôler par rapport à la surface L de référence. Ces informations de sortie sont ensuite utilisées pour commander, si besoin en est, les moyens précités de réglage en distance 5 et en rotation 6, 7 du support 3 afin d'amener l'élément 4 dans la position correcte vis-à-vis de la face L de référence.

Pour que les moyens 17 de traitement soient en mesure de discriminer les deux images lumineuses 16L, 16w formées alternativement sur les capteurs optroniques 15, on prévoit des moyens de synchronisation entre les moyens 8 émetteurs de lumière et, par exemple, les moyens de traitement 17 pour établir une relation entre les deux faisceaux FL, Fw émis par les moyens émetteurs de lumière 8 de façon alternative et les deux images 16L, 16w formées sur les capteurs optroniques 15 de façon alternative. En pratique, ces moyens de synchronisation peuvent être intégrés dans les moyens de traitement 17 et une liaison 17a peut être prévue à cet effet entre les moyens 8 émetteurs de lumière et les moyens de traitement 17.

Les moyens capteurs 14 peuvent être agencés de toute manière appropriée permettant de délivrer l'information énergétique barycentrique recherchée. Notamment, il est possible d'envisager la mise en oeuvre de matrices de diodes CCD ou de transistors CMOS. Toutefois, il semble que, dans l'état actuel de la technique, la solution la mieux appropriée consiste en ce que chaque capteur 15 des moyens capteurs 14 soit un capteur photosensible du type sensible à la position PSD (Position Sensitive Detector) propre à délivrer deux signaux de sortie représentatifs de la position du barycentre énergétique de chacune des deux images lumineuses 16L, 16w reçues par le capteur. L'intérêt de ce type de capteur réside dans son électronique associée qui est peu importante et peu encombrante et dans sa très grande précision (bien inférieure à 1 µm sur une longueur de quelques millimètres).

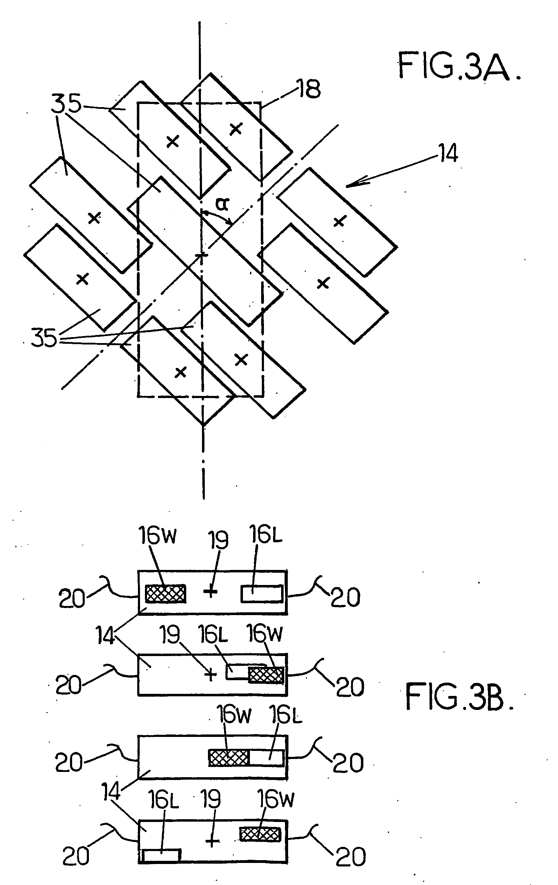

Le nombre des capteurs à mettre en oeuvre dépend de la précision de mesure souhaitée, de l'importance de l'aire couverte par les faisceaux multiples sur la surface W à contrôler, et surtout des limites imposées par l'optique quant au nombre des faisceaux susceptibles d'être transmis. A la figure 3A, on a représenté en tirets un exemple de contour de l'image 18 représentant le champ couvert par les faisceaux lumineux Fw' sur la surface W, correspondant à la portion de la surface W dont on cherche à estimer l'attitude (une distance et deux angles) ; pour fixer les idées, ce champ peut être de forme rectangulaire, de l'ordre de 20 à 30 mm en longueur et 6 à 12 mm en largeur. Dans l'exemple illustré à la figure 3A, on a représenté neuf taches 35 sensiblement rectangulaires réparties à peu près symétriquement autour d'une tache centrale à l'intérieur ou à proximité du champ image 18 (ce qui implique la mise en oeuvre de neuf faisceaux parallèles issus de la division du faisceau source). Les taches lumineuses peuvent être de forme quelconque et positionnées dans n'importe quelle disposition propre à procurer la meilleure efficacité de détection ; par exemple, les taches rectangulaires 35 sont orientées sous un angle α d'environ 45 degrés par rapport aux axes du champ.

A la figure 3B, on a représenté de façon agrandie, toujours à titre d'exemple, un groupe de quatre capteurs 15 sur lesquels sont indiqués les centres respectifs (croix 19) ainsi que les taches lumineuses de contour sensiblement rectangulaire respectivement 16L (tache blanche) et 16w (tache quadrillée). Les références 20 désignent les deux connexions reliant les deux sorties de chaque capteur 15 aux moyens 17 de traitement. Comme indiqué plus haut, les signaux de sortie des capteurs 15 sont représentatifs de la position du barycentre énergétique lumineux des deux taches 16L, 16w par rapport au centre 19 servant de référence de positionnement. Tout déplacement Δh de la surface W par rapport à la surface L, que ce déplacement soit dû à un écartement perpendiculaire aux deux surfaces selon la direction z ou à une inclinaison, se traduit par un déplacement d'une tache 16w sur au moins un capteur 15.

On soulignera qu'outre la très grande précision de détection de position permise par ce type de capteur, un avantage supplémentaire réside dans le fait que, du fait de la détection barycentrique, la forme des taches ainsi que la position exacte des taches 16L et 16w n'entre pas en ligne de compte. Seule compte la distance relative entre les deux barycentres des deux taches 16L et 16w. En particulier, il n'est pas nécessaire de procéder à un réglage initial très précis des taches 16L procurées par la surface de référence ; il suffit que ces taches soient positionnées sur le capteur correspondant. On privilégie cependant un positionnement proche du centre du capteur, ce qui correspond à l'optimum de performances intrinsèques du capteur.

Les moyens 17 de traitement des signaux procurés par les capteurs 15 sont agencés, de toute façon connue de l'homme du métier, pour effectuer un algorithme de calcul, en particulier du calcul matriciel, et fournissent des informations respectivement de la meilleure estimation de l'écartement d et des meilleures estimations des deux angles d'inclinaison respectivement selon deux directions de la surface W à contrôler par rapport à la surface L de référence.

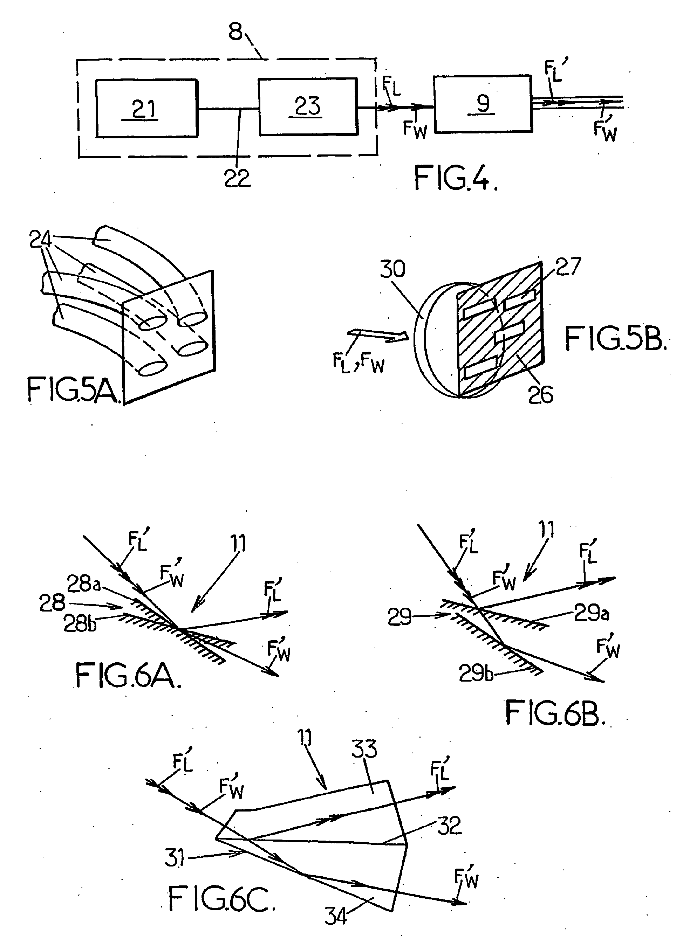

Les moyens 8 émetteurs de lumière peuvent comprendre, comme montré à la figure 4 :
- une source (ou plusieurs sources combinées) 21 de lumière émettant un faisceau lumineux 22 unique dans une bande de longueurs d'ondes englobant les susdites première et seconde plages ΔλL et Δλw, et
- un modulateur optique 23 propre à isoler, dans ledit faisceau lumineux 22 unique, des faisceaux ayant des longueurs d'onde correspondant aux susdites première et seconde plages ΔλL et Δλw de longueurs d'ondes, notamment dans le cadre de l'exemple envisagé plus haut la plage ΔλL d'environ 600 - 630 nm pour le faisceau dirigé vers la surface de référence et la plage Δλw d'environ 670 - 1050 nm pour le faisceau dirigé vers la surface à contrôler, et ceci de façon alternée dans le temps selon un cycle de fréquence prédéterminée, notamment avec une fréquence du cycle comprise entre 1 et 10 kHz, de préférence d'environ 2,5 kHz, dans le cadre dudit exemple.

Quant aux moyens diviseurs de faisceau 9, plusieurs solutions peuvent être envisagées. On peut envisager, comme illustré à la figure 5A, que les faisceaux multiples proviennent de sources multiples sous forme de fibres optiques 24 supportées par un support 25 selon la configuration géométrique appropriée pour former le réseau de taches lumineuses souhaité. De façon simple et actuellement préférée, comme illustré à la figure 5B on constitue les moyens diviseurs de faisceau sous forme d'une plaque 26, formant écran, éclairée par les faisceaux FL et Fw à travers une optique d'illumination 30, cette plaque étant perforée de plusieurs trous 27 de forme choisie et répartis selon la configuration géométrique requise pour l'obtention du motif de taches lumineuses souhaité.

Enfin, le séparateur optique 11 et le combineur optique 12 sont des composants optiques statiques opérant par réfraction et réflexion en fonction des plages de longueurs d'onde ΔλL et Δλw. On peut envisager des solutions techniques mettant en oeuvre des miroirs : bi-miroir 28 faisant appel à deux miroirs 28a, 28b juxtaposés ayant des inclinaisons différentes comme montré à la figure 6A ; ou bien double miroir 29 faisant appel à deux miroirs successifs comme montré à la figure 6B, le premier miroir 29a étant par exemple réfléchissant pour la lumière de la plage ΔλL et réfracteur pour la lumière de la plage Δλw tandis que le second miroir placé derrière celui-ci reçoit la lumière de la plage Δλw pour laquelle il est réfléchissant. Toutefois, la solution actuellement préférée consiste à réaliser le séparateur optique 11 et le combineur optique 12 sous forme d'un assemblage prismatique 31 formé de deux lames accolées 33, 34 dont l'interface 32 est réfléchissante pour la lumière par exemple de la plage ΔλL et réfractrice pour la lumière de l'autre plage Δλw comme montré à la figure 6C.

## Revendications

1. Dispositif de mesure optique par triangulation optique pour la mesure, par rapport à une surface (L) plane de référence et selon une direction sensiblement perpendiculaire à celle-ci, de l'écartement (d) et de l'inclinaison selon deux directions d'une surface (W) à contrôler qui est localement assimilable à un plan,
**caractérisé en ce qu'**il comprend :
- des moyens (8) émetteurs de lumière propres à émettre sur une même trajectoire, avec une fréquence de répétition donnée, deux faisceaux lumineux (FL, Fw) alternatifs respectivement dans une première plage (ΔλL) de longueurs d'onde et dans une seconde plage (Δλw) de longueurs d'onde,
- des moyens (9) diviseurs de faisceau propres à générer, à partir de chaque faisceau incident (FL, Fw) unique, plusieurs faisceaux lumineux séparés et parallèles (FL', Fw') en nombre au moins égal à trois répartis selon une configuration prédéterminée,
- un séparateur optique (11) propre à diriger chacun des faisceaux lumineux (FL', Fw') incidents dans deux directions différentes en relation respectivement avec les deux plages (ΔλL, Δλw) de longueurs d'onde, ledit séparateur optique (11) étant disposé latéralement, par rapport à la surface (L) de référence et à la surface (W) à contrôler, de manière que les deux faisceaux (FL', Fw') de sortie soient dirigés, avec des trajets de sensiblement mêmes longueurs, respectivement vers la surface (L) de référence et la surface (W) à contrôler sur lesquelles ils subissent des réflexions respectives (FL", Fw") de manière à converger ensuite l'un vers l'autre,
- un combineur optique (12) de faisceaux propre à recueillir les deux faisceaux réfléchis (FL", Fw") issus d'un même faisceau incident et à les diriger alternativement sur un même trajet optique de sortie,
- des moyens capteurs (14) pour recevoir chacun desdits faisceaux (FL", Fw") alternatifs de sortie, lesdits moyens capteurs (14) comprenant des capteurs optroniques (15)
• qui sont en nombre inférieur ou égal à celui des faisceaux lumineux multiples,
• qui sont disposés selon une configuration corrélée à celle des faisceaux lumineux multiples de manière telle que chaque capteur optronique (15) reçoive alternativement deux images lumineuses (16L, 16w) formées respectivement par les deux faisceaux réfléchis (FL', Fw') alternatifs, et
• qui sont propres à délivrer (en 20) un signal de sortie représentatif de la position du barycentre énergétique de chacune des deux images lumineuses (16L, 16w),
- des moyens (17, 18) de synchronisation pour établir une relation temporelle entre les deux faisceaux (FL, Fw) alternatifs émis par les moyens (8) émetteurs de lumière et respectivement les deux images (16L, 16w) formées sur les capteurs optroniques (15), et
- des moyens (17) de traitement de l'ensemble des signaux délivrés par les capteurs optroniques (15) pour fournir des informations d'écartement et d'inclinaison selon deux directions de la surface (W) à contrôler par rapport à la surface (L) de référence.

2. Dispositif selon la revendication 1, **caractérisé en ce que** chaque capteur (15) des moyens capteurs (14) est un capteur photosensible du type sensible à la position propre à délivrer deux signaux de sortie représentatifs de la position du barycentre énergétique de chacune des deux images lumineuses reçues par le capteur.

3. Dispositif selon la revendication 1 ou 2, **caractérisé en ce que** les moyens (8) émetteurs de lumière comprennent :
- au moins une source (21) de lumière émettant un faisceau lumineux (22) unique dans une bande de longueurs d'ondes englobant les susdites première et seconde plages (ΔλL, Δλw) et
- un modulateur optique (23) propre à isoler, dans ledit faisceau lumineux (22) unique, lesdites première et seconde plages de longueurs d'ondes de façon alternée dans le temps selon un cycle de fréquence prédéterminée.

4. Dispositif selon la revendication 3, **caractérisé en ce que** la fréquence du cycle est comprise entre 1 et 10 kHz, et de préférence est d'environ 2,5 kHz.

5. Dispositif selon l'une quelconque des revendications 1 à 4, **caractérisé en ce que** les moyens (8) émetteurs de lumière émettent dans le rouge et/ou le proche infrarouge.

6. Dispositif selon la revendication 5, **caractérisé en ce que** les susdites deux plages de longueurs d'ondes sont respectivement la plage d'environ 600 - 630 nm pour le faisceau dirigé vers la surface de référence et la plage d'environ 670 - 1050 nm pour le faisceau dirigé vers la surface à contrôler.

7. Dispositif selon l'une quelconque des revendications 1 à 6, **caractérisé en ce que** les moyens (9) diviseurs de faisceau comprennent un écran (26) qui comporte au moins trois trous (27) de forme prédéfinie disposés selon une configuration prédéterminée et qui est propre à être éclairé alternativement par lesdits faisceaux lumineux (FL, Fw).

8. Dispositif selon l'une quelconque des revendications 1 à 7, **caractérisé en ce que** le séparateur optique (11) et le combineur optique (12) sont des composants optiques statiques opérant par réfraction et réflexion en fonction des longueurs d'onde.

## Claims

1. An optical measuring device using optical triangulation for measuring, relative to a plane reference surface (L) and in a direction substantially perpendicular thereto, the distance (d) and the inclination in two directions of a surface (W) to be checked, which-locally can be likened to a plane,
**characterized in that** it comprises:
- light emitter means (8) suitable for emitting along a same path, with a given repetition frequency, two alternating light beams (F_{L}, F_{W}) in a first wavelength range (Δλ_{L}) and in a second wavelength range (Δλ_{W}), respectively;
- beam divider means (9) suitable for generating, from each single incident beam (F_{L}, F_{W}), several separate parallel light beams (F'_{L}, F'_{W}), being at least three in number and distributed in a predetermined configuration;
- an optical splitter (11) suitable for directing each of the incident light beams (F'_{L}, F'_{W}) in two different directions in relation to the two wavelength ranges (Δλ_{L}, Δλ_{W}) respectively, said optical splitter (11) being placed laterally relative to the reference surface (L) and to the surface (W) to be checked, so that the two output beams (F'_{L}, F'w) are directed, along paths of substantially the same lengths, into respectively the reference surface (L) and the surface (W) to be checked, off which they undergo respective reflections (F"_{L}, F"_{W}) so as thereafter to converge on each other;
- an optical beam combiner (12) suitable for collecting the two reflected beams (F"_{L}, F"_{W}) coming from the same incident beam and for directing them alternately along one and the same optical output path;
- sensor means (14) for receiving each of said alternating output beams (F"_{L}, F"_{W}), said sensor means (14) comprising optronic sensors (15):
• which are fewer than or the same in number as that of the multiple light beams,
• which are placed in a configuration that is correlated with that of the multiple light beams in such a way that each optronic sensor (15) receives alternately two light images (16_{L}, 16_{W}) formed by the two alternate reflected beams (F'_{L}, F'_{W}) respectively, and
• which are suitable for delivering (at 20) an output signal representative of the position of the energy barycenter of each of the two light images (16_{L}, 16_{W});
- synchronization means (17, 18) for establishing a temporal relationship between the two alternate beams (F_{L}, F_{W}) emitted by the light emitter means (8) and the two images (16_{L}, 16_{W}) respectively formed on the optronic sensors (15); and
- processing means (17) for processing all of the signals delivered by the optronic sensors (15) in order to provide information about the distance and inclination in two directions of the surface (W) to be checked relative to the reference surface (L).

2. The device as claimed in claim 1, **characterized in that** each sensor (15) of the sensor means (14) is a photosensitive sensor of the position-sensitive type suitable for delivering two output signals representative of the position of the energy barycenter of each of the two light images received by the sensor.

3. The device as claimed in claim 1 or 2, **characterized in that** the light emitter means (8) comprise:
- at least one light source (21) emitting a single light beam (22) in a wavelength band encompassing said first and second ranges (Δλ_{L}, Δλ_{W}); and
- an optical modulator (23) arranged for isolating, in said single light beam (22), said first and second wavelength ranges alternately over time in a predetermined frequency cycle.

4. The device as claimed in claim 3, **characterized in that** the frequency of the cycle is between 1 and 10 kHz, and preferably about 2.5 kHz.

5. The device as claimed in any one of claims 1 to 4, **characterized in that** the light emitter means (8) emit in the red and/or in the near infrared.

6. The device as claimed in claim 5, **characterized in that** said two wavelength ranges are respectively the about 600
- 630 nm range in the case of the beam directed onto the reference surface and the about 670 - 1050 nm range in the case of the beam directed onto the surface to be checked.

7. The device as claimed in any one of claims 1 to 6, **characterized in that** the beam splitter means (9) comprise a screen (26) which has at least three holes (27) of predefined shape arranged in a predetermined configuration which is adapted for being illuminated alternately by said light beams (F_{L}, F_{W}).

8. The device as claimed in any one of claims 1 to 7, **characterized in that** the optical splitter (11) and the optical combiner (12) are static optical components operating by refraction and reflection in relation with the wavelengths.

## Patentansprüche

1. Vorrichtung zur optischen Messung durch optische Triangulation, um bezüglich einer ebenen Bezugsfläche- (L) und gemäß einer dazu im Wesentlichen lotrechten Richtung den Abstand (d) und die Neigung gemäß zwei Richtungen einer zu prüfenden Fläche (W) zu messen, die lokal einer Ebene gleichgesetzt werden kann, **dadurch gekennzeichnet, dass** sie aufweist:
- Licht emittierende Mittel (8), die auf einer gleichen Bahn mit einer gegebenen Wiederholungsfrequenz zwei abwechselnde Lichtstrahlen (FL, Fw) in einem ersten Wellenlängenbereich (ΔλL) bzw. in einem zweiten Wellenlängenbereich (Δλw) emittieren können,
- Strahlteilermittel (9), die ausgehend von jedem einzelnen einfallenden Strahl (FL, Fw) mehrere getrennte und parallele Lichtstrahlen (FL', Fw') in einer Anzahl von mindestens gleich drei erzeugen können, die gemäß einer vorbestimmten Konfiguration verteilt sind,
- einen optischen Separator (11), der jeden der einfallenden Lichtstrahlen (FL', Fw') in zwei unterschiedliche Richtungen jeweils in Verbindung mit den zwei Wellenlängenbereichen (ΔλL, Δλw) lenken kann, wobei der optische Separator (11) derart seitlich bezüglich der Bezugsfläche (L) und der zu prüfenden Fläche (W) angeordnet ist, dass die zwei Ausgangsstrahlen (FL', Fw') mit Strecken von im Wesentlichen gleicher Länge in Richtung der Bezugsfläche (L) bzw. der zu prüfenden Fläche (W) gelenkt werden, auf denen sie jeweilige Reflexionen (FL", Fw") erfahren, um anschließend zueinander zu konvergieren,
- einen optischen Strahlenkombinierer (12), der die zwei von dem gleichen einfallenden Strahl stammenden reflektierten Strahlen (FL", Fw") auffangen und sie abwechselnd auf die gleiche optische Ausgangsstrecke lenken kann,
- Sensormittel (14), um jeden der abwechselnden Ausgangsstrahlen (FL", Fw") zu empfangen, wobei die Sensormittel (14) optronische Sensoren (15) aufweisen,
• die in einer Anzahl geringer als die oder gleich derjenigen der mehreren Lichtstrahlen vorliegen,
• die gemäß einer Konfiguration angeordnet sind, die mit derjenigen der mehreren Lichtstrahlen derart korreliert ist, dass jeder optronische Sensor (15) abwechselnd zwei leuchtende Bilder (16L, 16w) empfängt, die je von den zwei abwechselnden reflektierten Strahlen (FL', Fw') gebildet werden, und
• die (in 20) ein Ausgangssignal liefern können, das für die Position des energetischen Schwerpunkts jedes der zwei leuchtenden Bilder (16L, 16w) repräsentativ ist,
- Synchronisationsmittel (17, 18), um eine zeitliche Beziehung zwischen den zwei abwechselnden Strahlen (FL, Fw), die von den Licht emittierenden Mitteln (8) emittiert werden, und den zwei Bildern (16L, 16w) herzustellen, die in den optronischen Sensoren (15) geformt werden, und
- Mittel (17) zur Verarbeitung der Gesamtheit der von den optronischen Sensoren (15) gelieferten Signale, um Informationen des Abstands und der Neigung gemäß zwei Richtungen der zu prüfenden Fläche (W) bezüglich der Bezugsfläche (L) zu liefern.

2. Vorrichtung nach Anspruch 1, **dadurch gekennzeichnet, dass** jeder Sensor (15) der Sensormittel (14) ein lichtempfindlicher Sensor vom positionsempfindlichen Typ ist, der zwei Ausgangssignale liefern kann, die für die Position des energetischen Schwerpunkts jedes der zwei leuchtenden Bilder repräsentativ sind, die von dem Sensor empfangen werden.

3. Vorrichtung nach Anspruch 1 oder 2, **dadurch gekennzeichnet, dass** die Licht emittierenden Mittel (8) aufweisen:
- mindestens eine Lichtquelle (21), die einen einzigen Lichtstrahl (22) in einem Wellenlängenband sendet, das den ersten und den zweiten Bereich (ΔλL, Δλw) umfasst, und
- einen optischen Modulator (23), der in dem einzigen Lichtstrahl (22) den ersten und den zweiten Wellenlängenbereich zeitlich abwechselnd gemäß einem vorbestimmten Frequenzzyklus isolieren kann.

4. Vorrichtung nach Anspruch 3, **dadurch gekennzeichnet, dass** die Frequenz des Zyklus zwischen 1 und 10 kHz liegt und vorzugsweise etwa 2,5 kHz beträgt.

5. Vorrichtung nach einem der Ansprüche 1 bis 4, **dadurch gekennzeichnet, dass** die Licht emittierenden Mittel (8) im Rotbereich und/oder im nahen Infrarotbereich emittieren.

6. Vorrichtung nach Anspruch 5, **dadurch gekennzeichnet, dass** die erwähnten zwei Wellenlängenbereiche der Bereich von etwa 600 - 630 nm für den zur Referenzfläche gelenkten Strahl, bzw. der Bereich von etwa 670 - 1050 nm für den zur zu prüfenden Fläche gelenkten Strahl sind.

7. Vorrichtung nach einem der Ansprüche 1 bis 6, **dadurch gekennzeichnet, dass** die Strahlteilermittel (9) einen Schirm (26) aufweisen, der mindestens drei Löcher (27) mit vordefinierter Form aufweist, die gemäß einer vorbestimmten Konfiguration angeordnet sind, und der abwechselnd von den Lichtstrahlen (FL, Fw) beleuchtet werden kann.

8. Vorrichtung nach einem der Ansprüche 1 bis 7, **dadurch gekennzeichnet, dass** der optische Separator (11) und der optische Kombinierer (12) statische optische Bauteile sind, die durch Brechung und Reflektion in Abhängigkeit von den Wellenlängen arbeiten.
